# EUROPÄISCHE PATENTANMELDUNG

(11) **EP 3 901 698 A1**
(43) Veröffentlichungstag der Anmeldung: **27.10.2021**
(21) Anmeldenummer: 21173586.5
(22) Anmeldetag: 06.09.2012
(51) Int. Cl.: G03F 7/00, B29C 59/02, B82Y 40/00, B82Y 10/00, B29C 59/00

(54) **STRUKTURSTEMPEL, VORRICHTUNG UND VERFAHREN ZUM PRÄGEN**

(62) Teilanmeldung aus: 15173112.2
(71) Anmelder: EV Group E. Thallner GmbH, 4782 St. Florian am Inn (AT)
(72) Erfinder: Fischer, Peter, 4782 St. Florian am Inn (AT); Kreindl, Gerhard, 4782 St. Florian am Inn (AT); Harming, Jakob, 4782 St. Florian am Inn (AT); Thanner, Christine, 4782 St. Florian am Inn (AT); Schön, Christian, 4782 St. Florian am Inn (AT)
(74) Vertreter: Schneider, Sascha

(57) **Zusammenfassung**

Die Erfindung betrifft einen Strukturstempel (5) mit
- einer eine mikro- oder nanostrukturierten Stempelfläche (2) zur Prägung einer zu der Stempelfläche (2) korrespondierenden Prägestruktur auf einer Prägefläche (6o) aufweisenden, flexiblen Stempelfolie (1),
- einem Rahmen (3) zum Einspannen der Stempelfolie (1).

Darüber hinaus betrifft die Erfindung eine Vorrichtung zum Prägen eines Prägemusters auf einer Prägefläche () mit folgenden Merkmalen:
- eine Stempelaufnahme zur Aufnahme und Bewegung eines Strukturstempels (5) nach einem der vorhergehenden Ansprüche,
- einer Prägematerialaufnahme zur Aufnahme und Anordnung eines Prägematerials (6) gegenüber dem Strukturstempel (5),
- einen Prägeelementantrieb zur Bewegung eines, insbesondere nach einem der Ansprüche 3, 4 7 oder 8 ausgebildeten, Prägeelements (8) entlang des Strukturstempels (5).

Weiterhin betrifft die vorliegende Erfindung ein korrespondierendes Verfahren.

## Beschreibung

Die vorliegende Erfindung betrifft einen Strukturstempel zum Prägen gemäß Patentanspruch 1, eine Vorrichtung gemäß Patentanspruch 9 und ein Verfahren gemäß Patentanspruch 10.

Der heutige Stand der Technik für die Mirko- und/oder Nanostrukturierung von Oberflächen umfasst vor allem die Photolithographie und die unterschiedlichen Prägetechniken. Die Prägetechniken arbeiten entweder mit harten oder weichen Stempeln. In letzter Zeit setzen sich vor allem die Prägelithographietechniken durch und verdrängen die klassischen Photolithographietechniken. Unter den Prägelithographietechniken wird vor allem die Verwendung von sogenannten weichen Stempeln immer beliebter. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen Verformung des Stempels während der Entformung. In der Softlithographie wird ein Stempel aus einem Elastomer mit einer mikro- bzw. nanotrukturierten Oberfläche verwendet, um Strukturen im Bereich von 20 nm bis >1000 µm herzustellen.

Es gibt sechs bekannte Techniken:
- Mikro- und/oder Nanokontaktdrucken (µ/nCP)
- Replikagießen (REM)
- Microtransfer moulding (µTM) oder nanoimprint lithographie (NIL),
- Mikroformung in Kapillaren (MIMIC)
- lösungsmittelunterstützten Mikroformen(SAMIM) und
- Phaseshift Lithographie.

Elastomere Stempel werden als Negativ eines Masters hergestellt. Beim Masterstempel handelt es sich um einen Hartstempel aus Metall oder Keramik, der durch entsprechend aufwendige Prozesse einmal hergestellt wird. Aus dem Master können dann beliebig viele Elastomere Stempel hergestellt werden. Die elastomeren Stempel ermöglichen einen konformen, gleichmäßigen Kontakt über große Oberflächen. Sie sind leicht von ihrem starren Masterstempel, sowie von den Prägeprodukten zu trennen. Weiterhin haben elastomere Stempel eine geringe Oberflächenspannung für eine leichte und einfache Trennung von Stempel und Substrat. Zur automatisierten Realisierung von soft lithographischen Prozessen ist es nötig, den elastomeren Stempel durch einen Träger zu unterstützen. Derzeit werden Glasträgersubstrate mit verschiedenen Dicken verwendet. Durch die Verwendung dicker Glassubstrate verliert der elastomere Stempel allerdings seine Flexibilität zumindest teilweise.

Die Verwendung von starren Trägern erschwert das automatische Trennen von Stempel und Substrat nach dem Prägeprozess wodurch eine Prozessautomatisierung und eine industrielle Verwertbarkeit der Imprintlithographie nur schwer möglich sind.

Aufgabe der vorliegenden Erfindung ist es daher, eine Vorrichtung und ein Verfahren für die Mirko- und/oder Nanostrukturierung anzugeben, mit welchen eine Automatisierung und ein schnellerer Prozessablauf gewährleistet werden können.

Diese Aufgabe wird mit den Merkmalen der Patentansprüche 1, 9 und 10 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Den angegebenen Wertebereichen sollen auch innerhalb der genannten Grenzen liegende Werte als Grenzwerte offenbart und in beliebiger Kombination beanspruchbar sein.

Die Erfindung beschreibt ein Verfahren und eine Vorrichtung, bei welchen ein mikro- und/oder nanostrukturierten, insbesondere zumindest teilweise, vorzugsweise überwiegend, elastomeren, Strukturstempel, insbesondere Folienstempel, verwendet wird. Der Strukturstempel wird auf einer Beaufschlagungsseite des Strukturstempels erfindungsgemäß entlang seiner gesamten Länge, insbesondere in einem kontinuierlichen Prozess, mit einer, insbesondere sich quer zur Länge erstreckenden, Linienkraft beaufschlagt, um die Strukturen in das Prägematerial zu drücken. Mit Vorzug erfolgt die Beaufschlagung mit Hilfe eines Prägeelements, insbesondere einer, vorzugsweise starren, Prägerolle.

Linienkraft gemäß der vorliegenden Erfindung heißt, dass die Kraftbeaufschlagung zwar in einer ersten Richtung, insbesondere quer zur Bewegung eines Prägeelements entlang des Strukturstempels, zumindest überwiegend, insbesondere vollständig, erfolgt (also beispielsweise die gesamte wirksame Breite des Strukturstempels erfasst), während in einer zweiten Richtung (insbesondere quer zur ersten Richtung) nur ein vergleichsweise sehr kleiner Bereich (insbesondere im Verhältnis 1 zu 5, vorzugsweise 1 zu 10, noch bevorzugter 1 zu 20, noch bevorzugter 1 zu 100 zur ersten Richtung) gleichzeitig beaufschlagt wird. Somit ergibt sich eine vergleichsweise kleine Beaufschlagungsfläche im Verhältnis zur Gesamtfläche des Strukturstempels, die gleichzeitig beaufschlagt wird. Hierdurch wird nicht nur eine sehr definierte Beaufschlagung ermöglicht, sondern auch eine sehr homogene Prägung erreicht. Die Erfindung erlaubt somit außerdem eine großflächige Anwendung des Prägeverfahrens, insbesondere mit einer Breite größer als 0,5 m, vorzugsweise größer 1 m, und/oder einer Länge größer als 0,5 m, vorzugsweise größer 1 m, noch bevorzugter größer 2 m.

Durch die erfindungsgemäße Anordnung des Strukturstempels in einem modulartigen Rahmen wird eine Automatisierung des Verfahrens und somit ein schnellerer Prozessablauf ermöglicht.

Der erfindungsgemäße Strukturstempel wird weitergebildet, indem die Stempelfolie ausschließlich an zwei gegenüberliegenden Spannseiten des Rahmens eingespannt ist, insbesondere mittels zwei an den zwei gegenüberliegenden Seiten angeordneten Spannleisten. Die Spannleisten umfassen insbesondere Fixiermittel zur Fixierung der Stempelfolie entlang der Breite des Strukturstempels.

Gemäß einer vorteilhaften Ausführungsform der Erfindung ist vorgesehen, dass der Rahmen zwei gegenüberliegend, insbesondere parallel zueinander, verlaufende Führungsleisten zur Führung eines Prägeelements, insbesondere einer Prägerolle, entlang einer zur Stempelfläche abgewandten Seite der Stempelfolie angeordneten Beaufschlagungsseite der Stempelfolie aufweist. Somit wird die Bewegung des Prägeelements unmittelbar dem die Stempelfolie fixierenden Rahmen zugeordnet, quasi entkoppelt von der das Prägeelement antreibenden Vorrichtung zur Aufnahme des Strukturstempels und einer Steuerung des Strukturstempels mit einer Steuerungseinrichtung.

Soweit die Stempelfolie derart flexibel ausgebildet ist, dass die Stempelfolie mittels eines Prägeelements über eine von den Rahmen, insbesondere durch die Führungsleisten, definierte Oberflächenebene hinaus dehnbar ist, wird die Ausrichtung des Strukturstempels gegenüber der zu prägenden Prägefläche erleichtert und insbesondere leichter automatisierbar.

In Weiterbildung der vorliegenden Erfindung ist es vorgesehen, dass die Stempelfolie aus einer Trägerfolie und einem hierauf gemoldeten oder heißgeprägten, insbesondere elastomeren, Stempel gebildet ist. Hierdurch wird die Herstellung des Strukturstempels günstiger.

Indem der Strukturstempel einen den Rahmen an seiner zur Stempelfläche abgewandten Seite aufnehmenden Halterahmen umfasst, wird die Automatisierung, insbesondere das Auswechseln des Strukturstempels, weiter vereinfacht, da eine Schnittstelle zwischen der erfindungsgemäßen Vorrichtung und dem Strukturstempel beziehungsweise dem Rahmen des Strukturstempels zur Verfügung gestellt wird. Der vorgenannte Halterahmen ist, insbesondere in Verbindung mit einem entlang des Rahmens geführten Prägeelement als eigenständige Erfindung anzusehen.

Dabei ist es in Weiterbildung der Erfindung und/oder des Halterahmens denkbar, das Prägeelement zwischen dem Halterahmen und dem Rahmen, insbesondere parallel zu den gegenüberliegenden Spannseiten derart zu führen, dass das Prägeelement entlang der Stempelfolie führbar ist und diese dabei mit einer Prägekraft beaufschlagend ausgebildet ist.

Als eigenständige Erfindung wird außerdem eine Vorrichtung zum Prägen eines Prägemusters auf einer Prägefläche mit folgenden Merkmalen offenbart:
- eine Stempelaufnahme zur Aufnahme und Bewegung eines Strukturstempels, insbesondere gemäß eines vorbeschriebenen Strukturstempels,
- einer Prägematerialaufnahme zur Aufnahme und Anordnung eines Prägematerials gegenüber dem Strukturstempel,
- einen Prägeelementantrieb zur Bewegung eines, insbesondere nach einem wie vorliegend beschrieben ausgebildeten, Prägeelements entlang des Strukturstempels.

Vorrichtungsgemäß wird auch eine Steuerungseinrichtung zur Steuerung des beschriebenen, erfindungsgemäßen Verfahrens und zur Ausführung der beschriebenen Bewegungen der Bauteile der Vorrichtung und/oder des Strukturstempels, insbesondere des Halterahmens, des Rahmens oder des Prägeelements, einzeln oder gemeinsam, offenbart. Entsprechende Antriebe und Führungselemente zur Ausführung der Bewegungen werden hierdurch ebenfalls der Vorrichtung zugeordnet.

Als eigenständige Erfindung wird außerdem ein Verfahren zum Prägen eines Prägemusters auf einer Prägefläche eines Prägematerials mit folgenden Schritten, insbesondere folgendem Ablauf, offenbart:
- der Stempelfläche eines Strukturstempels, insbesondere gemäß obiger Beschreibung, gegenüber dem Prägematerial,
- Bewegung eines Prägeelements entlang des Strukturstempels und dabei prägendes Prägematerials durch Beaufschlagung des Prägematerials mit der Stempelfläche.

Dabei ist es vorteilhaft, wenn die Stempelfolie flexibel ausgebildet und beim Prägen durch das Prägeelement über eine von dem Rahmen, insbesondere durch Führungsleisten definierte Oberflächenebene hinaus gedehnt wird.

Weiterhin ist es erfindungsgemäß von Vorteil, den Rahmen an seiner zur Stempelfläche abgewandten Seite von einem Halterahmen aufzunehmen.

Dabei ist es gemäß einer vorteilhaften Ausführungsform des Verfahrens vorgesehen, dass das Prägeelement zwischen dem Halterahmen und dem Rahmen, insbesondere parallel zu den gegenüberliegenden Spannseiten, entlang der Stempelfolie geführt wird und diese dabei mit einer Prägekraft beaufschlagt wird.

Vorrichtungsgemäß offenbarte Merkmale der Vorrichtung und/oder des Strukturstempels sollen auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in schematischer Ansicht:
- Figur 1: eine schematische Querschnittsansicht einer ersten Ausführungsform der vorliegenden Erfindung, nämlich eines erfindungsgemäßen ersten Verfahrensschrittes der Ausrichtung eines erfindungsgemäßen Strukturstempels gegenüber einem auf einem Substrat aufgebrachten Prägematerial,
- Figur 2: eine schematische Querschnittsansicht eines erfindungsgemäßen zweiten Verfahrensschrittes der Annäherung des Strukturstempels an das zu prägende Prägematerial,
- Figur 3: eine schematische Querschnittsansicht eines dritten Verfahrensschrittes der Beaufschlagung des Strukturstempels mit einem Prägeelement (Beginn des Prägens),
- Figur 4: eine schematische Ansicht des Verfahrensschritts gemäß Figur 3 beim Ende des Prägens,
- Figur 5: eine schematische Querschnittsansicht einer zweiten Ausführungsform des erfindungsgemäßen Verfahrens und
- Figur 6: eine schematische perspektivische Ansicht des erfindungsgemäßen Struktursubstrats mit einem erfindungsgemäßen Prägeelement.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig, was insbesondere auf stark vergrößert dargestellte Nanostrukturen 2e zurückzuführen ist. Die Nanostrukturen 2e, die mit der vorliegenden Erfindung geprägt werden beziehungsweise zum Prägen von korrespondierenden Nanostrukturen auf Werkstücke verwendet werden, liegen im Nano- und/oder Mikrometerbereich, während die Größenordnung der Maschinenbauteile im Zentimeterbereich liegt.

Die Abmessungen der einzelnen Nanostrukturen 2e des Prägemusters 2 liegen vorzugsweise im Mikrometer- und/oder im Nanometerbereich. Die Abmessungen der einzelnen Nanostrukturen 2e sind kleiner als 1000 µm, mit Vorzug kleiner als 10 µm, mit größerem Vorzug kleiner als 100 nm, mit noch größerem Vorzug kleiner als 10 nm, mit allergrößtem Vorzug kleiner als 1 nm.

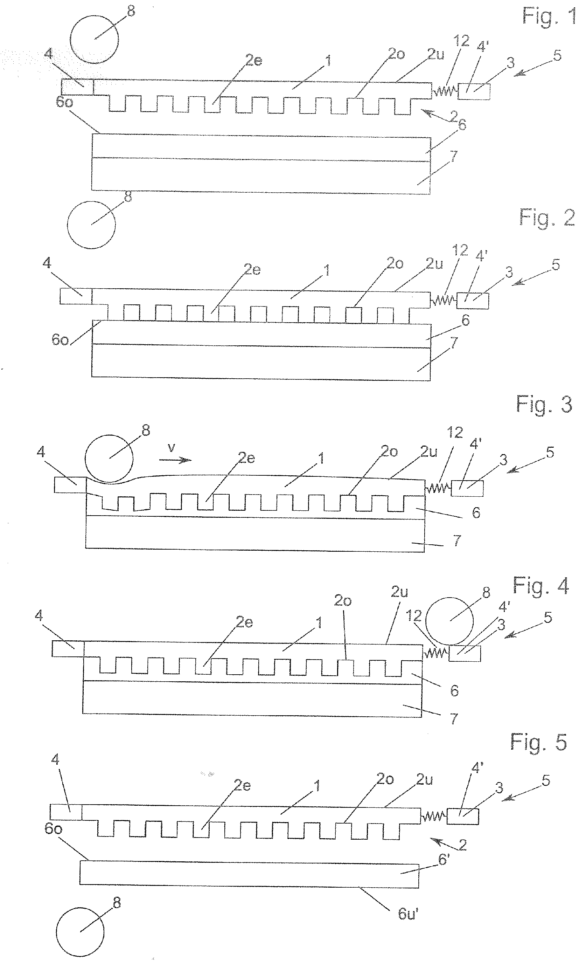

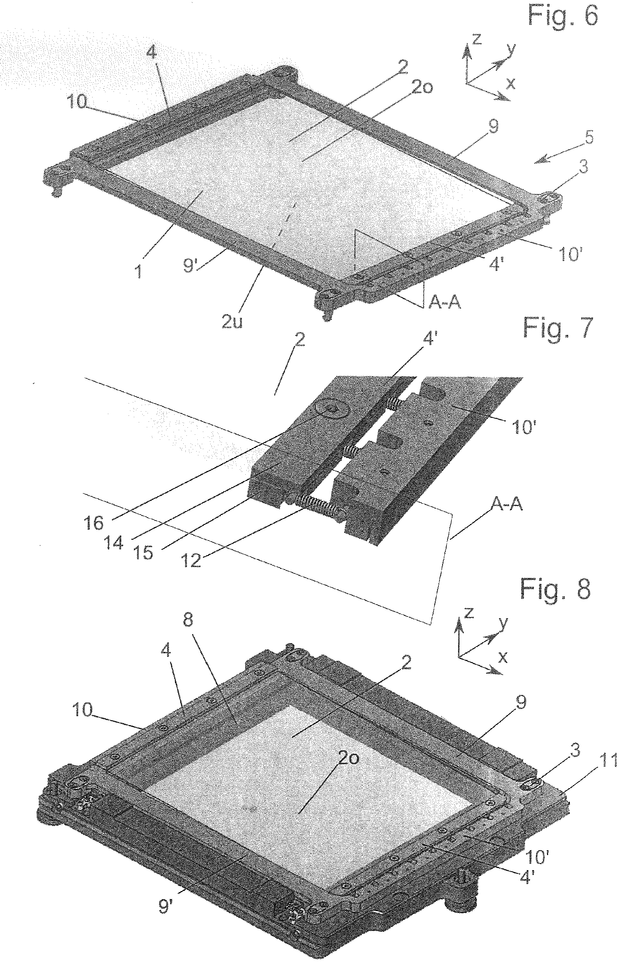

In der in Figuren 1 bis 4 und 6 gezeigten ersten Ausführungsform ist ein Strukturstempel 5 gezeigt, der aus einem Rahmen 3 und einer in den Rahmen 3 eingespannten Stempelfolie 1 besteht.

Die Stempelfolie 1 besitzt eine mikro- oder nanostrukturierte Stempelfläche 2 mit den Nanostrukturen 2e (Erhebungen), die von einer Trägerseite 2o der Stempelfolie 1 hervorstehen.

Eine zur Stempelfläche 2 gegenüberliegende Beaufschlagungsseite 2u ist plan eben ausgebildet, damit eine möglichst homogene Beaufschlagung der Stempelfolie 1 an der Beaufschlagungsseite 2u ermöglicht wird.

Zur Beaufschlagung dient ein Prägeelement 8, hier in Form einer Prägerolle, die nach Ausrichtung des Strukturstempels 5 gegenüber einem auf einem Substrat 7 aufgebrachten Prägematerial 6 (siehe Figur 1) und anschließendem Annähern des Strukturstempels 5 an eine Prägefläche 6o des Prägematerials 6 auf die Beaufschlagungsseite 2u abgesenkt wird.

Der Rahmen 3 besteht aus zwei gegenüberliegenden Spannseiten 4, 4', in welche die Stempelfolie 1 eingespannt ist, insbesondere mittels zwei an den zwei gegenüberliegenden Seiten angeordneten, nicht dargestellten Spannleisten.

Die beiden Spannseiten 4, 4' werden durch zwei gegenüberliegend, parallel zueinander verlaufende Führungsleisten 9, 9' verbunden, wobei die Führungsleisten 9, 9' insbesondere nicht mit der Stempelfolie 1 in Berührung kommen. Die Stempelfolie 1 verläuft vorzugsweise innerhalb und zwischen den Führungsleisten 9, 9'.

Die Beaufschlagung der Beaufschlagungsseite 2u mit dem Prägeelement 8 erfolgt insbesondere gleichzeitig mit einer Kontaktierung beziehungsweise einem Eintauchen der Nanostrukturen 2e in das Prägematerial 6 (siehe Figur 3), wobei die Annäherung des Strukturstempels 5 an das Prägematerial 6 gemäß Figur 2 unter leichter Anwinklung des Strukturstempels 5 zunächst an einer der beiden Spannseiten 4, 4' (hier zunächst Spannseite 4) erfolgt. Die Nanostrukturen 2e tauchen somit nach und nach in das, insbesondere aus einem Material niedriger Viskosität bestehende, Prägematerial 6 ein und während des weiteren Annäherns des Strukturstempels 5 an das Prägematerial 6 wird unter Parallelisierung der Stempelfolie 1 mit dem Prägematerial 6 eine Prägekraft auf die Beaufschlagungsseite 2u durch das Prägeelement 8 übertragen. Dabei verformt sich die Stempelfolie 1 in Richtung des Prägematerials über eine von dem Rahmen 3, insbesondere durch die Führungsleisten 9, 9', definierte Oberflächenebene E hinaus.

Das Prägeelement 8 wird unter Annäherung der Stempelfolie 1 und Parallelisierung der Stempelfolie 1 zu dem Prägematerial 6, insbesondere überwiegend durch die Prägekraft des Prägeelements 8 bewirkt, von der ersten Spannseite 4 zur gegenüberliegend angeordneten zweiten Spannseite 4' parallel zu der Oberfläche des Prägematerials 6 bewegt.

Nach Erreichen der Position gemäß Figur 4 ist die Stempelfläche 2 vollständig in dem Prägematerial 6 eingetaucht und dort entsprechend abgebildet.

Anschließend erfolgt eine Aushärtung des Prägematerials 6 und nach Aushärtung des Prägematerials 6 kann der Strukturstempel 5 abgehoben werden.

Der Einsatz einer Prägerolle als Prägeelement 8 bringt den Vorteil einer abrollenden Bewegung und Druckbeaufschlagung mit der Prägekraft mit sich, was zu einer Minimierung von Scherkräften auf die Stempelfolie 1 führt.

Gemäß der in Figur 5 gezeigten weiteren Ausführungsform erfolgt die Druckbeaufschlagung mit dem Prägeelement 8 von der gegenüberliegenden Seite, also von der Rückseite 6u des Prägematerials 6' her, wobei eine entsprechende Gegenkraft auch hier wirkt, insbesondere durch Halterung des Rahmens 3. Das Prägematerial 6' wäre in diesem Fall zur Druckübertragung selbst geeignet oder gegebenenfalls durch ein Substrat 7 unterstützt, wie bei der Ausführungsform gemäß Figuren 1 bis 4 gezeigt.

Das Prägeelement 8 kann derart ausgeführt sein, dass eine kontaktlose Kraftübertragung, insbesondere durch einen Luftstrom aus einer linienförmigen Düse oder mehreren entlang einer Linie angeordneten, punktförmigen Düsen, erfolgt.

### Bezugszeichenliste

- 1: Stempelfolie
- 2: Stempelfläche
- 2e: Nanostrukturen
- 2o: Prägeseite
- 2u: Beaufschlagungsseite
- 3: Rahmen
- 4, 4': Spannseiten
- 5: Strukturstempel
- 6, 6': Prägematerial
- 6o: Prägefläche
- 6u: Rückseite
- 7: Substrat
- 8: Prägeelement
- 9, 9': Führungsleisten
- E: Oberflächenebene

## Patentansprüche

1. Strukturstempel (5) mit
- einer eine mikro- oder nanostrukturierten Stempelfläche (2) zur Prägung einer zu der Stempelfläche (2) korrespondierenden Prägestruktur auf einer Prägefläche (60) aufweisenden, flexiblen Stempelfolie (1),
- einem Rahmen (3) zum Einspannen der Stempelfolie (1).

2. Strukturstempel (5) nach Anspruch 1, wobei die Stempelfolie (1) ausschließlich an zwei gegenüberliegenden Spannseiten (4, 4') des Rahmens (3) eingespannt ist, insbesondere mittels zwei an den zwei gegenüberliegenden Seiten angeordneten Spannleisten.

3. Strukturstempel (5) nach Anspruch 1 oder 2, bei dem der Rahmen (3) zwei gegenüberliegend, insbesondere parallel zueinander, verlaufende Führungsleisten (9, 9') zur Führung eines Prägeelements (8), insbesondere einer Prägerolle, entlang einer zur Stempelfläche (2) abgewandten Seite der Stempelfolie (1) angeordneten Beaufschlagungsseite (2u) der Stempelfolie (1) aufweist.

4. Strukturstempel nach einem der vorhergehenden Ansprüche, bei dem die Stempelfolie (1) derart flexibel ausgebildet ist, dass die Stempelfolie (1) mittels eines Prägeelements (8) über eine von dem Rahmen (3), insbesondere durch die Führungsleisten (9, 9'), definierte Oberflächenebene E hinaus dehnbar ist.

5. Strukturstempel nach einem der vorhergehenden Ansprüche, bei dem die Stempelfolie (1) aus einer Trägerfolie und einem hierauf gemoldeten oder heißgeprägten, insbesondere elastomeren, Stempel gebildet ist.

6. Strukturstempel nach einem der vorhergehenden Ansprüche mit einem den Rahmen (3) an seiner zur Stempelfläche (2) abgewandten Seite aufnehmenden Halterahmen.

7. Strukturstempel nach einem der vorhergehenden Ansprüche mit einem am entlang des Rahmens (3) geführten Prägeelement (8).

8. Strukturstempel nach Anspruch 6 und 7, bei dem das Prägeelement (8) zwischen dem Halterahmen und dem Rahmen (3), insbesondere parallel zu den gegenüberliegenden Spannseiten (4, 4'), derart geführt ist, dass das Prägeelement (8) entlang der Stempelfolie (1) führbar ist und diese dabei mit einer Prägekraft beaufschlagend ausgebildet ist.

9. Vorrichtung zum Prägen eines Prägemusters auf einer Prägefläche () mit folgenden Merkmalen:
- eine Stempelaufnahme zur Aufnahme und Bewegung eines Strukturstempels (5) nach einem der vorhergehenden Ansprüche,
- einer Prägematerialaufnahme zur Aufnahme und Anordnung eines Prägematerials (6) gegenüber dem Strukturstempel (5),
- einen Prägeelementantrieb zur Bewegung eines, insbesondere nach einem der Ansprüche 3, 4 7 oder 8 ausgebildeten, Prägeelements (8) entlang des Strukturstempels (5).

10. Verfahren zum Prägen eines Prägemusters auf einer Prägefläche eines Prägematerials mit folgenden Schritten, insbesondere folgendem Ablauf:
- Anordnung der Stempelfläche eines Strukturstempels nach einem der Ansprüche 1 bis 8 gegenüber dem Prägematerial,
- Bewegung eines Prägeelementes entlang des Strukturstempels und dabei Prägen des Prägematerials durch Beaufschlagung des Prägematerials mit der Stempelfläche.

11. Verfahren nach Anspruch 10, bei dem die Stempelfolie flexibel ausgebildet und beim Prägen durch das Prägeelement über eine von dem Rahmen, insbesondere durch die Führungsleisten, definierte Oberflächenebene hinaus gedehnt wird.

12. Verfahren nach Anspruch 10 oder 11, bei dem der Rahmen an seiner zur Stempelfläche abgewandten Seite von einem Haltrahmen aufgenommen wird.

13. Verfahren nach Anspruch 12, bei dem das Prägeelement zwischen dem Halterahmen und dem Rahmen, insbesondere parallel zu den gegenüberliegenden Spannseiten, entlang der Stempelfolie geführt wird und diese dabei mit einer Prägekraft beaufschlagt wird.
